# EUROPEAN PATENT APPLICATION

(11) **EP 4 709 087 A2**
(43) Date of publication of application: **11.03.2026**
(21) Application number: 25194483.1
(22) Date of filing: 07.08.2025
(51) Int. Cl.: H10D 84/01, H10D 30/01, H10D 30/00, H10D 84/83, H10D 84/85, H10D 88/00

(54) **INTEGRATED CIRCUIT DEVICES AND METHODS OF FORMING THE SAME**

(30) Priority: 15.08.2024 US 202463683351 P; 25.03.2025 US 202519089809
(71) Applicant: SAMSUNG ELECTRONICS CO., LTD., Yeongtong-gu Suwon-si, Gyeonggi-do 16677 (KR)
(72) Inventor: PARK, Beomjin, San Jose, CA, 95134 (US); PARK, Kibyung, San Jose, CA, 95134 (US); PARK, Junmo, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

A semiconductor device includes a substrate, a lower channel stack on the substrate, an upper channel stack on the lower channel stack, a gate electrode extending around the lower channel stack and the upper channel stack, a gate cut region that is on the substrate and includes an insulating material, a semiconductor material layer between the upper channel stack and the gate cut region, and an insulating layer that is between the semiconductor material layer and the upper channel stack.

## Description

### FIELD

The present disclosure relates to integrated circuit devices.

### BACKGROUND

Integrated circuit devices may utilize stacked transistors to increase density and improve performance. In some instances, the stacked transistors may be complementary to each other (e.g., complementary metal-oxide-semiconductor (CMOS) transistors). For example, a complementary-FET (CFET) layout may include multiple vertically stacked pairs of gate-all-around field effect transistors (GAAFETs), with P-type GAAFETs on one-level, N-type GAAFETs on another level (i.e., above or below), and shared gates, where each shared gate extends between and wraps around the channel patterns of the stacked pair of N-type and P-type GAAFETs. In such structures, the source/drain regions of the lower GAAFET are electrically isolated from the source/drain regions of the upper GAAFET by dielectric layers. The gates, channel patterns, and isolation structures may be similar in dimensions between the upper and lower devices of the stacked transistors.

### SUMMARY

According to some embodiments, a semiconductor device includes a substrate, a lower channel stack on the substrate, an upper channel stack on the lower channel stack, a gate electrode extending around the lower channel stack and the upper channel stack, a gate cut region that is on the substrate and includes an insulating material, a semiconductor material layer between the upper channel stack and the gate cut region, and an insulating layer that is between the semiconductor material layer and the upper channel stack.

In some embodiments, the semiconductor material layer includes at least one of polycrystalline silicon, amorphous silicon, crystalline silicon, doped silicon, or germanium.

In some embodiments, the insulating layer includes at least one of silicon dioxide or a dielectric material having a dielectric constant greater than silicon dioxide.

In some embodiments, the upper channel stack includes a plurality of upper channel patterns, the insulating layer includes the silicon dioxide and the dielectric material, portions of the silicon dioxide respectively contact a first surface of each of the plurality of upper channel patterns, and portions of the dielectric material respectively contact a second surface of each of the plurality of upper channel patterns.

In some embodiments, a width of the semiconductor material layer in a first direction that is parallel to an upper surface of the substrate is less than or equal to 10 nm.

In some embodiments, the semiconductor material layer is between the lower channel stack and the gate cut region, and the insulating layer is between the semiconductor material layer and the lower channel stack.

In some embodiments, the lower channel stack includes a plurality of lower channel patterns, the insulating layer includes silicon dioxide and a dielectric material having a dielectric constant greater than silicon dioxide, portions of the silicon dioxide respectively contact a first surface of each of the plurality of lower channel patterns, and portions of the dielectric material respectively contact a second surface of each of the plurality of lower channel patterns.

In some embodiments, a width of each of the plurality of lower channel patterns in a first direction that is parallel to an upper surface of the substrate is greater than a width of each of the plurality of upper channel patterns in the first direction.

In some embodiments, the semiconductor device further includes a middle dielectric isolation layer between the lower channel stack and the upper channel stack.

In some embodiments, the lower channel stack and the semiconductor material layer are free from overlap in a first direction that is parallel to an upper surface of the substrate.

In some embodiments, a width of a lower portion of the semiconductor material layer in the first direction is less than a width of an upper portion of the semiconductor material layer in the first direction.

In some embodiments, the insulating layer contacts an upper surface of the substrate.

According to some embodiments, a semiconductor device includes a substrate, a lower channel stack that is on the substrate and includes a plurality of lower channel patterns, an upper channel stack that is on the lower channel stack and includes a plurality of upper channel patterns, a gate electrode extending around the lower channel stack and the upper channel stack, a gate cut region that is on the substrate and includes an insulating material, a semiconductor material layer that is between the upper channel stack and the gate cut region and is between the lower channel stack and the gate cut region, where the semiconductor material layer includes at least one of polycrystalline silicon, amorphous silicon, crystalline silicon, doped silicon, or germanium, and an insulating layer that is between the semiconductor material layer and the upper channel stack and is between the semiconductor material layer and the lower channel stack, where the insulating layer includes at least one of silicon dioxide or a dielectric material having a dielectric constant greater than silicon dioxide.

In some embodiments, the insulating layer includes the silicon dioxide and the dielectric material, portions of the silicon dioxide respectively contact a first surface of each of the plurality of upper channel patterns and a first surface of each of the plurality of lower channel patterns, and portions of the dielectric material respectively contact a second surface of each of the plurality of upper channel patterns and a second surface of each of the plurality of lower channel patterns.

In some embodiments, a width of the semiconductor material layer in a first direction that is parallel to an upper surface of the substrate is less than or equal to 10 nm.

In some embodiments, the insulating layer contacts an upper surface of the substrate.

According to some embodiments, a semiconductor device includes a substrate, a lower channel stack that is on the substrate and includes a plurality of lower channel patterns, an upper channel stack that is on the lower channel stack and includes a plurality of upper channel patterns, a gate electrode extending around the lower channel stack and the upper channel stack, a gate cut region that is on the substrate and includes an insulating material, a semiconductor material layer that is between the upper channel stack and the gate cut region and is free from overlap with the lower channel stack in a first direction that is parallel to an upper surface of the substrate, and an insulating layer that is between the semiconductor material layer and the upper channel stack and is between the semiconductor material layer and the lower channel stack.

In some embodiments, the semiconductor material layer includes at least one of polycrystalline silicon, amorphous silicon, crystalline silicon, doped silicon, or germanium.

In some embodiments, the insulating layer includes at least one of silicon dioxide or a dielectric material having a dielectric constant greater than silicon dioxide.

In some embodiments, the insulating layer includes the silicon dioxide and the dielectric material, portions of the silicon dioxide respectively contact a first surface of each of the plurality of upper channel patterns, a first surface of each of the plurality of lower channel patterns, and the upper surface of the substrate, and portions of the dielectric material respectively contact a second surface of each of the plurality of upper channel patterns and a second surface of each of the plurality of lower channel patterns.

According to some embodiments, a method of forming a semiconductor device includes forming a plurality of channel layers and sacrificial layers that are alternately stacked on a substrate, performing a first etching process on the plurality of channel layers and sacrificial layers to form channel patterns and sacrificial gate patterns, wherein the channel patterns comprise upper channel patterns and lower channel patterns, providing a blocking oxide layer on the channel patterns and the sacrificial gate patterns, providing a preliminary semiconductor material layer on the blocking oxide layer, forming a gate cut region on the substrate, performing a second etching process on the preliminary semiconductor material layer to remove a portion of the preliminary semiconductor material layer and to form a semiconductor material layer that is between the upper channel patterns and the gate cut region, forming an insulator layer on the semiconductor material layer, and forming a gate electrode extending around the lower channel patterns and the upper channel patterns.

In some embodiments, the second etching process is performed to form the semiconductor material layer between the lower channel patterns and the gate cut region.

In some embodiments, the second etching process is performed to form the semiconductor material layer that is free from overlap with the lower channel stack in a first direction that is parallel to an upper surface of the substrate.

In some embodiments, the semiconductor material layer comprises at least one of polycrystalline silicon, amorphous silicon, crystalline silicon, doped silicon, or germanium.

In some embodiments, forming the insulator layer on the semiconductor material layer further includes performing a third etching process to remove the sacrificial gate patterns and to form, based on the blocking oxide layer, a first portion of the insulator layer that is on the semiconductor material layer, and providing a second portion of the insulator layer on the semiconductor material layer.

In some embodiments, the insulating layer comprises at least one of silicon dioxide or a dielectric material having a dielectric constant greater than silicon dioxide.

Other devices, apparatus, and/or methods according to some embodiments will become apparent to one with skill in the art upon review of the following drawings and detailed description. It is intended that all such additional embodiments, in addition to any and all combinations of the above embodiments, be included within this description, be within the scope of the present disclosure, and be protected by the accompanying claims.

### ADVANTAGEOUS EFFECT OF INVENTION

The present invention provides a semiconductor device with improved performance and a method of manufacturing the same.

The semiconductor device with improved performance according to the present invention may include an insulating layer extending around an upper channel stack and a lower channel stack, thereby providing enhanced performance.

The semiconductor device of the present invention includes a semiconductor material layer and an insulating layer, which may be configured so as not to degrade gate control while suppressing parasitic capacitance.

By reducing the parasitic capacitance, the stacked transistor can operate with reduced power consumption at a given operating frequency.

### BRIEF DESCRIPTION OF THE DRAWINGS

FIG. 1 is a schematic plan view illustrating an example semiconductor devices according to some embodiments of the present disclosure.
FIGS. 2, 3A, 3B, 3C, and 3D are schematic cross-sectional views illustrating various configurations of the semiconductor device of FIG. 1 according to some embodiments of the present disclosure.
FIGS. 4A, 4B, 5A, and 5B are schematic cross-sectional views illustrating various configurations of example semiconductor devices according to some embodiments of the present disclosure.
FIGS. 6A, 6B, 6C, 6D, 6E, 6F, and 6G are schematic cross-sectional views illustrating methods of fabricating semiconductor devices according to some embodiments of the present disclosure.
FIG. 7 is a flowchart illustrating a method of fabricating semiconductor devices according to some embodiments of the present disclosure.
FIG. 8 is a flowchart illustrating a method of fabricating semiconductor devices according to some embodiments of the present disclosure.

### DETAILED DESCRIPTION OF EMBODIMENTS

In embodiments described herein, a stacked transistor structure may include a first transistor and a second transistor. The first transistor may be a first type of transistor (e.g., a n-type metal-oxide-semiconductor (NMOS) transistor) and the second transistor may be a second type of transistor (e.g., a p-type metal-oxide-semiconductor (PMOS) transistor). The first and second types of transistors may be complementary to each other (e.g., CMOS transistors), and in some embodiments the stacked transistor may be or may include a stack of CMOS transistors. The first and second transistors may be stacked in any order (e.g., with the first transistor on top of the second transistor, or the second transistor on top of the first transistor), resulting in a stack comprising a top device (also referred to herein as an upper device or upper transistor, relative to an underlying substrate) and a bottom device (also referred to herein as a lower device or lower transistor, relative to the underlying substrate). Gates, channels, and source/drain regions of the upper and lower devices may likewise be referred to by the terms "upper" and "lower" (e.g., upper/lower gates, upper/lower channels, upper/lower source/drain regions, and upper/lower inner spacers).

Some embodiments of the present disclosure may arise from the realization that parasitic capacitances may exist between components of a semiconductor device due to the relatively close proximity therebetween. Parasitic capacitance may inhibit one or more electrical, performance, and/or operational characteristics of the stacked transistor, such as an increased power consumption, inhibited signal integrity, and the like. As an example, in a fin field-effect transistor (FinFET), which includes a channel region extending vertically beyond a substrate (e.g., in a vertical direction that is perpendicular to an upper surface of the substrate), a parasitic capacitance may be present between a gate extension and gate contact, and it may be challenging to reduce the gate extension without affecting the channel width, the capacitance, power consumption, and gate controllability.

Embodiments of the present disclosure provide semiconductor devices having stacked transistor structures, such as a 3D-stacked field-effect transistor (3DSFET) in a CMOS configuration or a multibridge-channel field-effect transistor (MBCFET^{™}) in a CMOS configuration. The stacked transistor structures may include a semiconductor material layer and an insulating layer between a gate cut region and at least one of an upper channel stack or a lower channel stack. In some embodiments, the semiconductor material layer may be formed by selectively removing (e.g., partially removing) portions of one or more semiconductor layers (e.g., polysilicon layers) of the stacked transistor structure during a fabrication process, and the insulating layer may be formed to selectively contact respective portions of the channel stacks and/or the substrate. The semiconductor material layer and insulating layer may be configured to inhibit parasitic capacitances for an in-bound standard cell (e.g., a standard cell that is configured to perform one or more memory-based or logic-based operations), an out-bound standard cell (e.g., a standard cell that extends around the in-bound standard cells and is configured to perform, for example, one or more input/output (I/O) interfacing operations and/or electrostatic discharge (ESD) operations), and a mid-bound standard cell (e.g., a standard cell that is between the in-bound an out-bound standard cells and is configured to perform, for example, one or more voltage shifting operations, isolation operations, and/or clock-based operations). The semiconductor material layer and insulating layer may be configured to inhibit parasitic capacitances by reducing the gate extension of the stacked transistor without reducing the gate controllability (e.g., without reducing or degrading the short channel effect (SCE)). By reducing the parasitic capacitance, the stacked transistor may operate with reduced power consumption for a given operating frequency.

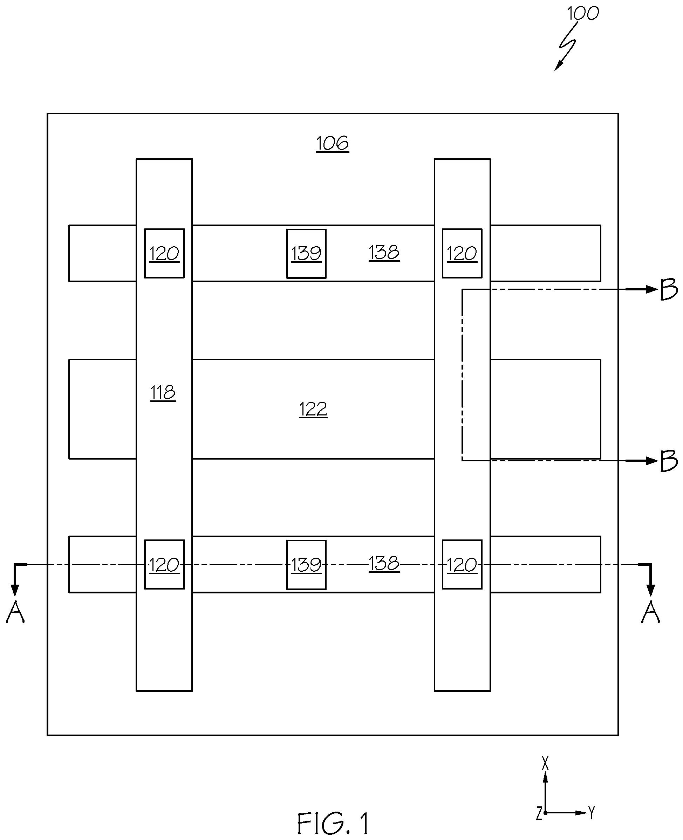

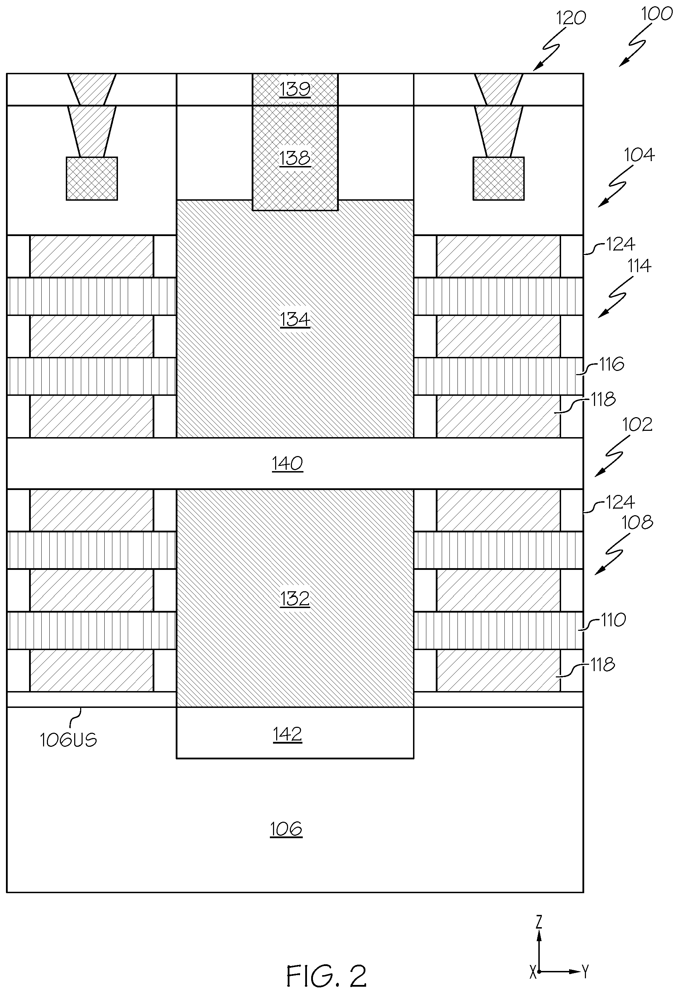

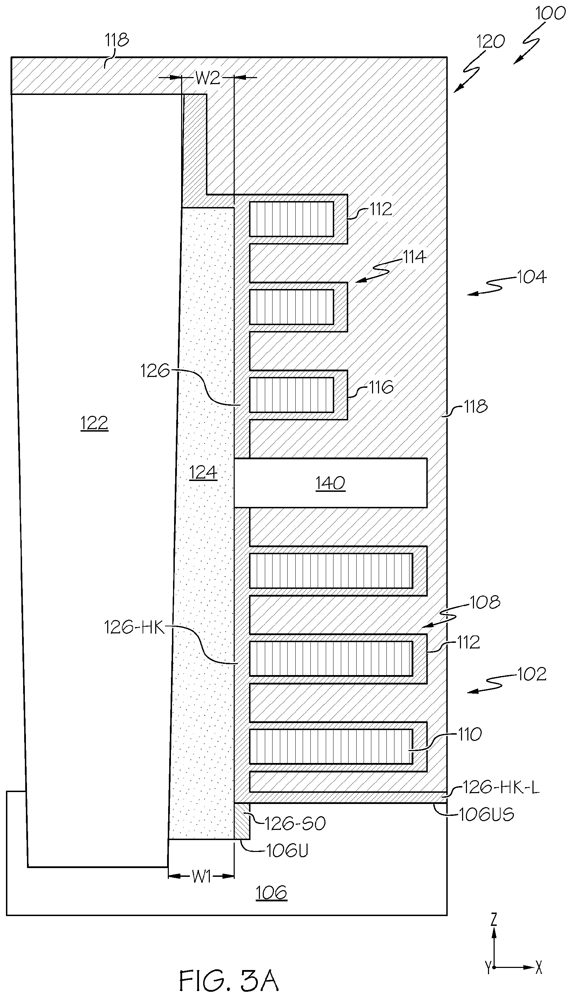

FIGS. 1, 2, and 3A-3D, a semiconductor device 100 according to some embodiments of the present disclosure is shown. FIG. 2 is an example cross-sectional view of the semiconductor device 100 along dashed line A-A in FIG. 1, and 3A-3D are example cross-sectional views of the semiconductor device 100 along dashed line B-B in FIG. 1.

In some embodiments, the semiconductor device 100 may be or include an out-bound standard cell. The semiconductor device 100 may have a stacked transistor structure including lower and upper transistors 102, 104 that are vertically stacked on a substrate 106. In some embodiments, the substrate 106 may include a semiconductor material, such as a group IV semiconductor, a group III-V compound semiconductor, or a group II-VI compound semiconductor. For example, the group IV semiconductor may include silicon, germanium, or silicon-germanium. The substrate 106 may be provided as a bulk wafer, an epitaxial layer, a silicon on insulator (SOI) layer, a semiconductor on insulator (SeOI) layer, or the like.

In some embodiments, the lower transistors 102 and upper transistors 104 have complementary conductivity types, e.g., to provide a CMOS device. In particular, the lower transistors 102 may have a first conductivity type (e.g., n-type), while the upper transistors 104 may have a second conductivity type (e.g., p-type) that is opposite to the first conductivity type, or vice versa. That is, stacked transistor structures according to embodiments of the present disclosure are not limited to particular orientations of transistors having the different conductivity types. Moreover, the lower and upper transistors 102 and 104 may have the same conductivity type (e.g., both the lower and upper transistors 102 and 104 may be n-type, or both the lower and upper transistors 102 and 104 may be p-type) in some embodiments. Also, while illustrated with reference to lower and upper transistors 102 and 104, it will be understood that stacked transistor structures according to embodiments of the present disclosure are not limited to a two-transistor arrangement, and may include additional transistors (e.g., third transistors, fourth transistors, etc.) that are vertically stacked on the substrate 106.

The lower transistor 102 may include a lower channel stack 108 comprising a plurality of lower channel patterns 110, and the upper transistor 104 may include an upper channel stack 114 comprising a plurality of upper channel patterns 116. The lower and upper channel patterns 110, 116 may include various types of semiconductor materials, such as silicon, germanium, gallium arsenide, and/or other known semiconductor materials. In the example of FIGS. 1, 2, and 3A-3D, multiple upper channel patterns 116 are vertically stacked (e.g., in the Z-axis direction, which is perpendicular to an uppermost surface 106US of the substrate 106) on multiple lower channel patterns 110, but embodiments of the present disclosure may include fewer or more channel patterns than shown. Each of the upper channel patterns 116 may have a width in the X-axis direction that is less than a width of each of the lower channel patterns 110 in the X-axis direction. In some embodiments, the widths of the upper channel patterns 116 in the X-axis direction may be the same or different from each other, and the widths of the lower channel patterns 110 in the X-axis direction may be the same or different from each other.

The lower and upper transistors 102, 104 may include a gate electrode 118 having one or more electrically conductive patterns extending around the lower and upper channel stacks 108, 114 and in the X-axis direction, which is parallel to the uppermost surface 106US of the substrate 106. In some embodiments, the gate electrode 118 may include various types of electrically conductive materials, such as doped polycrystalline silicon (Poly-Si), titanium nitride (TiN), tantalum nitride (TaN), molybdenum (Mo), cobalt, (Co), nickel silicide (NiSi), and/or other known electrically conductive materials.

The semiconductor device 100 may include a gate contact structure 120 including a gate contact that is electrically connected to the gate electrode 118 and a dielectric material that electrically isolates or separates the gate contact and gate electrode 118 from other portions of the semiconductor device 100. Although not shown in the drawings, it should be understood that the gate contact structure 120 may include one or more metal interconnect layers and/or barrier layers in some embodiments. While the gate contact structure 120 is shown on an upper region 118A of the gate pattens 118, the gate contact structure 120 may be provided on a lower surface 106L of the substrate 106 when the substrate 106 is an insulator in other embodiments.

The semiconductor device 100 may include a gate cut region 122 that extends in the Y-axis direction, which is parallel to the uppermost surface 106US of the substrate 106, and the Z-axis direction (e.g., vertically) such that it contacts, is on, and/or extends into the gate contact structure 120 and the substrate 106. The gate cut region 122 may include an insulating material, such as at least one of silicon nitride (SiN), silicon oxynitride (SiON), silicon carbonitride (SiCN), silicon oxycarbonitride (SiOCN), silicon boron nitride (SiBN), silicon oxyboron nitride (SiOBN), silicon oxycarbide (SiOC), and/or combinations thereof.

The semiconductor device 100 may include a semiconductor material layer 124 that is between the upper channel stack 114 and the gate cut region 122 and is between the lower channel stack 108 and the gate cut region 122. The semiconductor material layer 124 may extend in the Y-axis direction and the Z-axis direction such that it contacts and/or is on the gate contact structure 120, the gate electrode 118 (e.g., the upper region 118A of the gate electrode 118), and the substrate 106 (e.g., an upper surface 106U of the substrate 106). A width W1 of a lower portion of the semiconductor material layer 124 in the X-axis direction may be less than or equal to 10 nm. A width W2 of an upper portion of the semiconductor material layer 124 in the X-axis direction may be less than or equal to the width W1 of the lower surface of the semiconductor material layer 124. In some embodiments, the semiconductor material layer 124 comprises at least one of polycrystalline silicon, amorphous silicon, crystalline silicon, doped silicon, germanium, boron, or phosphorous. As described below in further detail, the semiconductor material layer 124 may be formed by removing some portions (and not removing other portions) of one or more preliminary semiconductor layers of the stacked transistor structure during the fabrication process.

The semiconductor device 100 may include an insulating layer 126 that is between and contacts the semiconductor material layer 124 and the upper channel stack 114 and is between and contacts the semiconductor material layer 124 and the lower channel stack 108. The insulating layer 126 may extend around the lower and upper channel stacks 108, 114 to thereby electrically isolate or separate the lower and upper channel stacks 108, 114 from the gate electrode 118 and the semiconductor material layer 124. The insulating layer 126 may extend in the Y-axis direction and the Z-axis direction such that it contacts and/or is on a side surface of the gate cut region 122, the uppermost and/or upper surfaces 106US, 106U of the substrate 106, each surface of the upper and lower channel stacks 114 and 108, and one or more surfaces of the gate electrode 118. Additional details regarding the fabrication of the insulating layer 126 are provided below.

In some embodiments, the insulating layer 126 may include at least one of silicon dioxide or a dielectric material having a dielectric constant greater than silicon dioxide (hereinafter referred to as a "high-k dielectric material") (e.g., hafnium dioxide, aluminum oxide, titanium dioxide, tantalum pentoxide, zirconium dioxide, barium strontium titanate, among other dielectric materials having a greater dielectric constant than silicon dioxide). In some embodiments, the insulating layer 126 may include silicon dioxide portions (also referred to herein as "blocking oxide portions") and/or high-k dielectric material portions that are selectively positioned on various components of the semiconductor device 100 to maintain a target gate controllability characteristic (e.g., the materials are selectively formed and position to inhibit the degradation of the SCE).

As an example and referring to FIG. 3A, the insulating layer 126 may include high-k dielectric material portions 126-HK that extend around each surface of each of the upper channel patterns 116 and the lower channel patterns 110 and extend along side surfaces of the gate electrode 118 and the gate cut region 122. The insulating layer 126 may also include a silicon dioxide portion 126-SO that is between and contacts the upper surface 106U of the substrate 106 and a lowermost one of the high-k dielectric material portions 126-HK-L that directly contacts the uppermost surface 106US of the substrate 106.

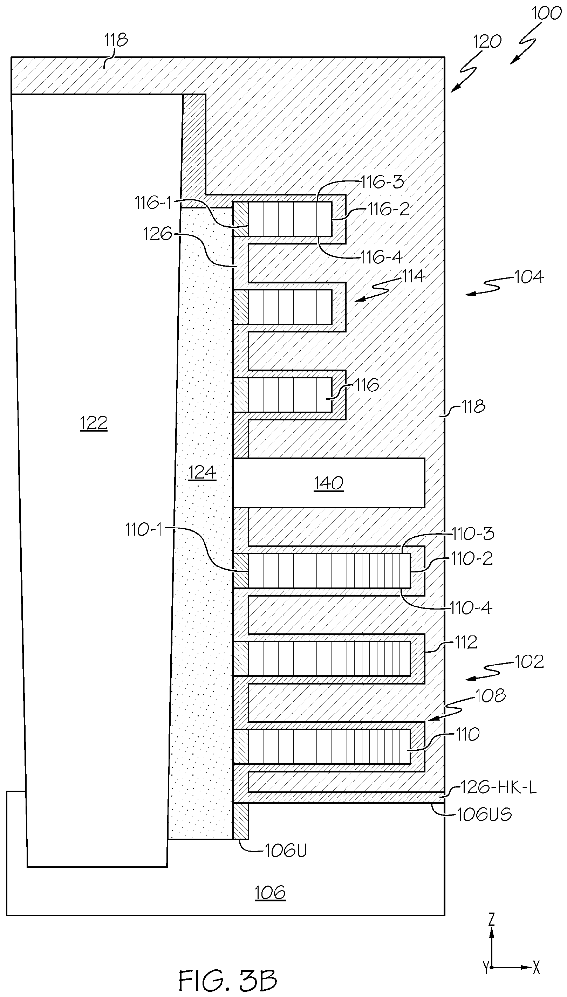

As another example and referring to FIG. 3B, the insulating layer 126 includes silicon dioxide portions 126-SO that respectively contact side surfaces 116-1 of each of the upper channel patterns 116, side surfaces 110-1 of each of the lower channel patterns 110, and the upper surface 106U of the substrate 106. The insulating layer 126 may also include high-k dielectric material portions 126-HK that respectively contact the surfaces 116-2, 116-3, 116-4 of each of the upper channel patterns 116, surfaces 110-2, 110-3, 110-4 of each of the lower channel patterns 110, and side surfaces of the gate electrode 118 and the gate cut region 122.

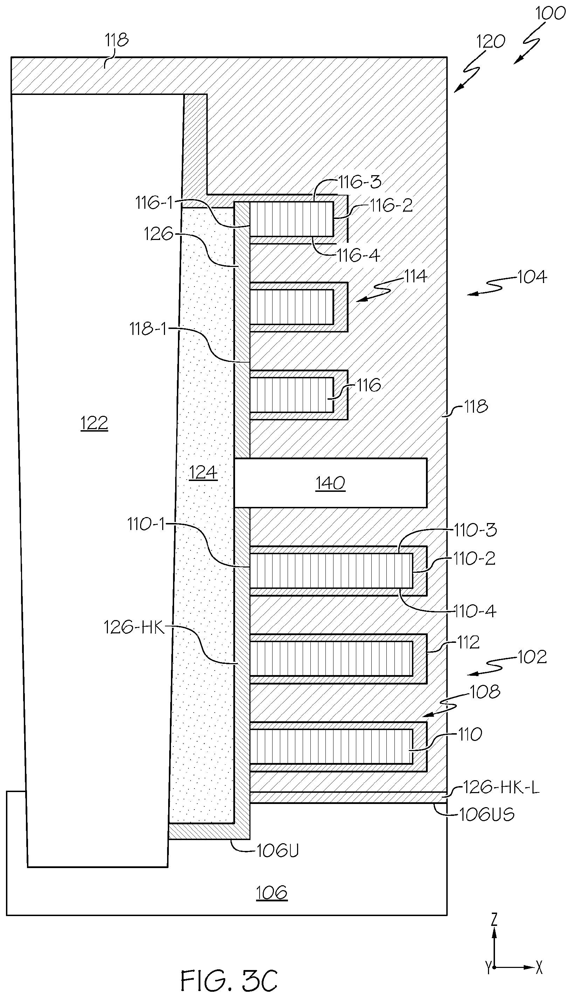

As yet another example and referring to FIG. 3C, the insulating layer 126 includes silicon dioxide portions 126-SO that respectively contact side surfaces 116-1 of each of the upper channel patterns 116, side surfaces 110-1 of each of the lower channel patterns 110, side surfaces of the gate electrode 118-1, and the upper surface 106U of the substrate 106. The insulating layer 126 may also include high-k dielectric material portions 126-HK that respectively contact the surfaces 116-2, 116-3, 116-4 of each of the upper channel patterns 116, surfaces 110-2, 110-3, 110-4 of each of the lower channel patterns 110, the upper region 118A of the gate electrode 118, a side surface of the gate cut region 122, and the uppermost surface 106US of the substrate 106.

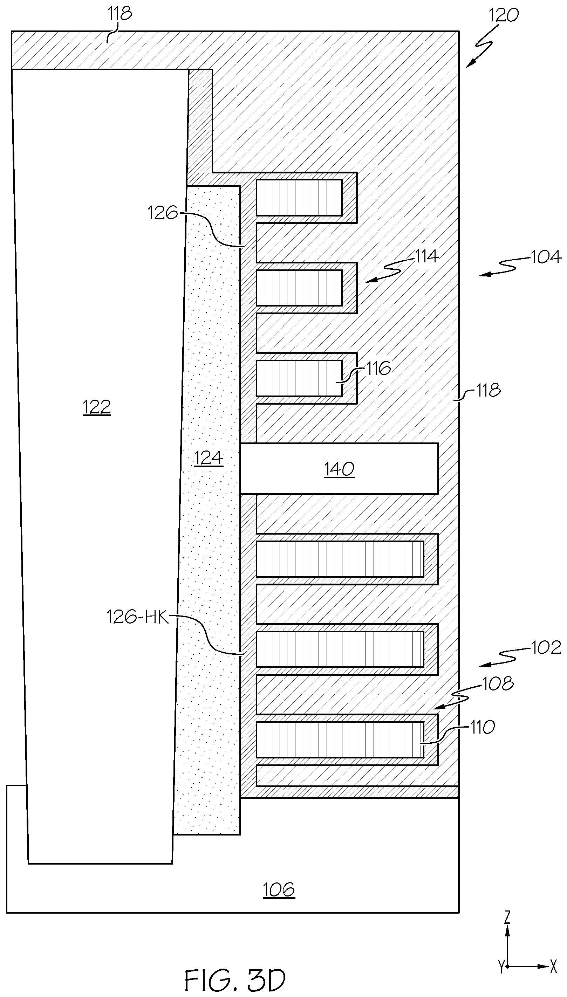

As an additional example and referring to FIG. 3D, the insulating layer 126 includes the high-k dielectric material portions 126-HK and does not include the silicon dioxide portions 126-SO. The high-k dielectric material portions 126-HK may extend around each surface of each of the upper channel patterns 116 and the lower channel patterns 110. The high-k dielectric material portions 126-HK may also contact the gate electrode 118, the gate cut region 122, the middle dielectric isolation layer 140, and the uppermost surface 106US of the substrate 106.

Referring to FIG. 2, lower source/drain regions 132 of the lower transistor 102 having a first conductivity type (e.g., n-type) may be provided on opposing sides (also referred to herein as opposing ends) of the lower channel patterns 110, and upper source/drain regions 134 of the upper transistor 104 having a second conductivity type that is opposite to the first conductivity type (e.g., p-type) are provided on opposing sides or ends of the upper channel patterns 116. In some embodiments, the lower source/drain regions 132 may include a same material or material composition as the lower channel patterns 110 and the substrate 106. For example, the lower channel patterns 110 and the lower source/drain regions 132 may be implemented as silicon layers. In some embodiments, the upper source/drain regions 134 may include a different material or material composition than the lower source/drain regions 132. For example, the upper channel patterns 116 may be implemented as silicon germanium (SiGe) layers. In some embodiments, the lower and upper source/drain regions 132, 134 may extend between portions of the gate electrode 118 and directly contact the lower and upper channel patterns 110, 116. The lower and upper channel patterns 110, 116 may extend in the Y-axis direction and may be between two adjacent source/drain regions 132, 134.

In some embodiments, source/drain electrodes 138 and source/drain contact structures 139 may be provided on and electrically connected to the lower and upper source/drain regions 132, 134. The source/drain contact structures may be electrically isolated or separated from each other and the gate contact structure 120. In some embodiments, the semiconductor device 100 may include a middle dielectric isolation layer 140 that includes insulating (e.g., oxidized) materials and may be provided between the lower channel patterns 110 and the upper channel patterns 116. The semiconductor device 100 may also include insulating regions 142 (e.g., leakage protection regions) that are in the substrate 106 and include oxide-based (e.g., silicon oxide) patterns or nitride-based (e.g., silicon nitride) patterns.

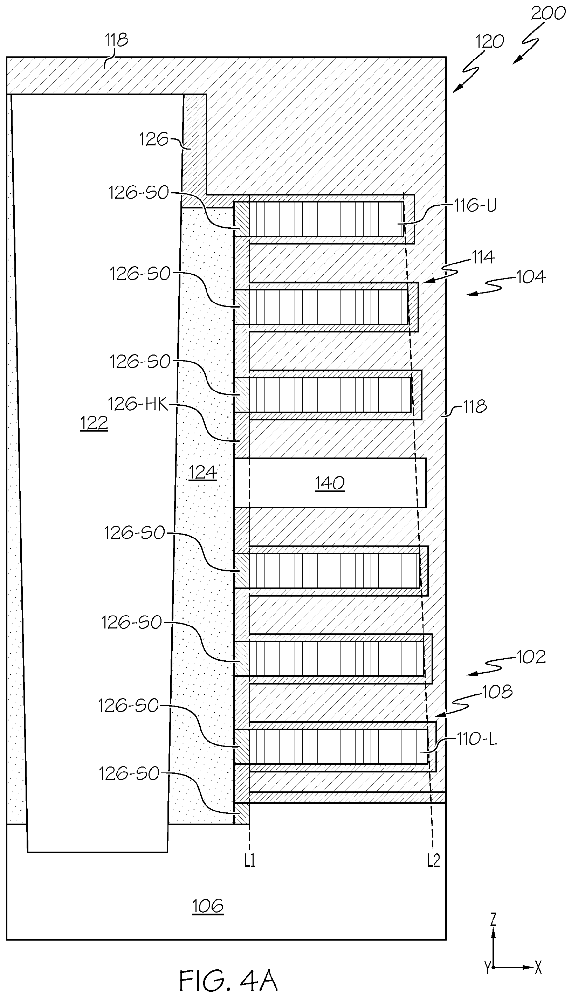

Referring to FIG. 4A, a cross-sectional view of a semiconductor device 200 according to some embodiments of the present disclosure is shown. The semiconductor device 200 may be similar to the semiconductor device 100 illustrated in FIGS. 1-2 and 3A-3D, except that a width in the X-axis direction of the upper channel patterns 116 and a width in the X-axis direction of the lower channel patterns 110 may be different from each other such that they gradually decrease from the uppermost surface 106US of the substrate(106) to the upper region 118A of the gate electrode 118. For example, the gradual increase may be configured such that a difference in width in the X-axis direction of an uppermost upper channel pattern 116-U and a lowermost lower channel pattern 110-L differs by a predetermined value (as indicated by dashed lines L1 and L2 in FIG. 4A), such as about 5%, 10%, 20%, among other example percentage differences. While the semiconductor device 200 illustrates the insulating layer 126 having a configuration substantially similar to the embodiment illustrated in FIG. 3B, it should be understood that the semiconductor device 200 may have the insulating layer 126 similar to the embodiment illustrated in FIGS. 3A, 3C, or 3D.

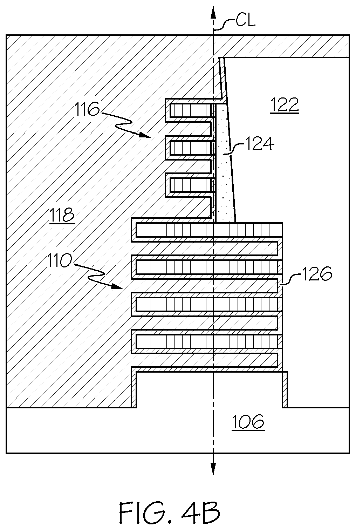

Referring to FIG. 4B, a cross-sectional view of a semiconductor device 250 according to some embodiments of the present disclosure is shown. The semiconductor device 250 may be similar to the semiconductor device 100 illustrated in FIGS. 1-2 and 3A-3D, except that a width in the X-axis direction of the upper channel patterns 116 may be a first width, and a width of the lower channel patterns 110 in the X-axis direction and may be a second width that is greater than the first width. Furthermore, a centerline CL of the lower channel patterns 108 may at least partially overlap the insulating layer 126, side surfaces of the gate electrode 118, or side surfaces of the upper and lower channel patterns 116, 110 in the Z-axis direction. While the semiconductor device 200 illustrates the insulating layer 126 having a configuration substantially similar to the embodiment illustrated in FIG. 3B, it should be understood that the semiconductor device 200 may have the insulating layer 126 similar to the embodiment illustrated in FIGS. 3A, 3C, or 3D.

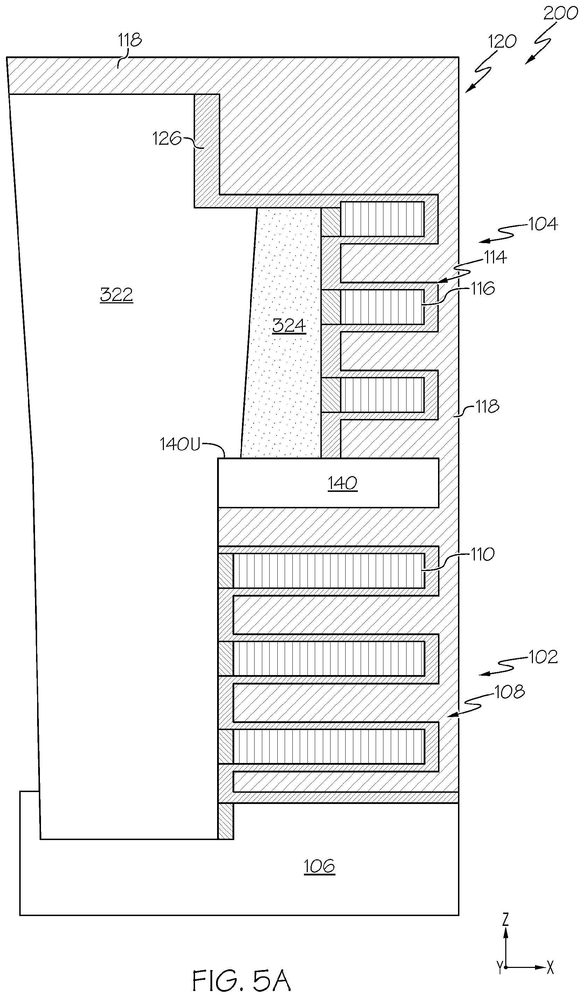

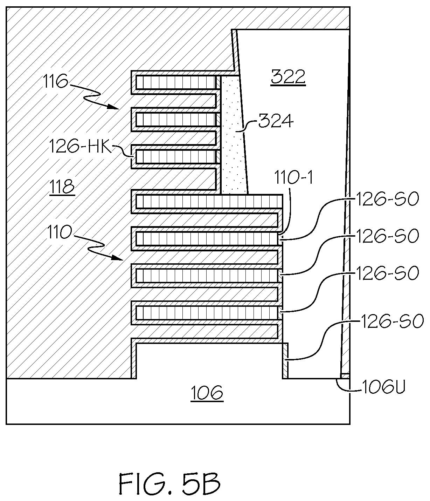

Referring to FIG. 5A, a cross-sectional view of a semiconductor device 300 according to some embodiments of the present disclosure is shown. In some embodiments, the semiconductor device 300 may include or be an in-bound standard cell. The semiconductor device 300 may be similar to the semiconductor device 100 illustrated in FIGS. 1-2 and 3A-3D, except that a gate cut region 322 (which is similar to the gate cut region 122) is on an upper surface 140U of the middle dielectric isolation layer 140 and the upper region 118A of the gate electrode 118. Furthermore, a semiconductor material layer 324 (which is similar to the semiconductor material layer 124) may extend between the upper region 118A of the gate electrode 118 and the upper surface 140U of the middle dielectric isolation layer 140 and is free from overlap in the X-axis direction with the lower channel stack 108. That is, the lower channel stack 108 and the gate cut region 322 may be free of the semiconductor material layer 324 therebetween. While the semiconductor device 300 illustrates the semiconductor material layer 324 overlapping the upper channel stack 114 and being free of overlap of the lower channel stack 108 in the X-axis direction, it should be understood that the semiconductor material layer 324 may be free of overlap with the upper channel stack 114 and may overlap the lower channel stack 108 in the X-axis direction in some embodiments. Furthermore, while the semiconductor device 300 illustrates the insulating layer 126 having a configuration substantially similar to the embodiment illustrated in FIG. 3B, it should be understood that the semiconductor device 300 may have the insulating layer 126 similar to the embodiment illustrated in FIGS. 3A, 3B, 3C, or 3D. As an example variation of the semiconductor device 300, and as shown in FIG. 5B, the insulating layer 126 may include the silicon dioxide portions 126-SO that respectively contact side surfaces 110-1 of each of the lower channel patterns 110 and the upper surface 106U of the substrate 106. The insulating layer 126 may also include high-k dielectric material portions 126-HK that respectively contact each surface of the upper channel patterns 116, surfaces 110-2, 110-3, 110-4 of each of the lower channel patterns 110, and side surfaces of the gate electrode 118 and the gate cut region 322.

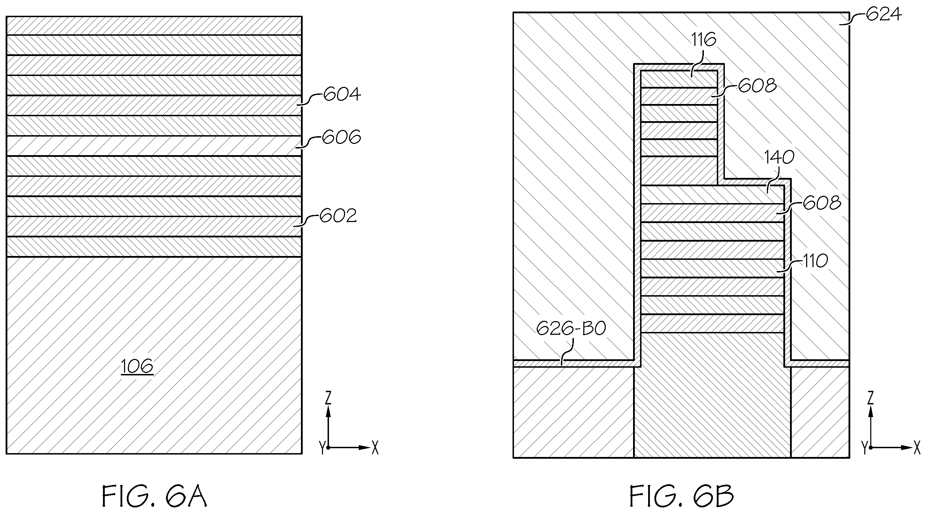

A method of forming semiconductor devices 100, 200, 250, and/or 300 is described below with reference to FIGS. 6A-6G, which illustrate schematic cross-sectional views depicting intermediate processes of forming the semiconductor device 100. It should be understood that certain steps may not be performed in various embodiments, and the order of the steps for forming the semiconductor devices 100, 200, 250, and/or 300 are not limited to the examples illustrated and described herein.

Referring to FIG. 6A, the method may include forming a plurality of channel layers 602 and sacrificial layers 604 that are alternatingly stacked on the substrate 106. In some embodiments, the method may further include forming a middle sacrificial layer 606 that is between a set of the sacrificial layers 604 (which may correspond to the lower and upper transistors 102 and 104). The middle sacrificial layer 606 may have a greater thickness than the sacrificial layers 604 in some embodiments. The plurality of channel layers 602 may include semiconductor materials, such as silicon (Si), and the sacrificial layers 604, 606 may include materials having etching selectivity with the materials of the channel layers 602, such as silicon germanium (SiGe).

Referring to FIG. 6B, the method may include forming the upper channel patterns 116, lower channel patterns 110, the middle dielectric isolation layer 140, and sacrificial gate patterns 608. In some embodiments, the respective lengths of the upper channel patterns 116 may be less than each of the respective lengths of the lower channel patterns 110 (e.g., semiconductor devices 100, 200, 250, or 300) and/or may differ amongst each other (e.g., semiconductor device 200). In some embodiments, the respective lengths of the upper sacrificial gate patterns 608 may be less than each of the respective lengths of the lower sacrificial gate patterns 608 (e.g., semiconductor devices 100, 200, 250, or 300) and/or may differ amongst each other (e.g., semiconductor device 200).

To form the channel patterns 110, 116, the middle dielectric isolation layer 140, and the sacrificial gate patterns 608, for example, the method may include performing a wet etching process and/or a dry etching process, such as plasma-enhanced etching, and using one or more mask patterns (not shown) to form the desired profile. The etching process may involve gases including, but not limited to, HBr, Cl₂, O₂, SF6, and N₂. In some embodiments, the etching process includes performing a dry etching process and controlling parameters thereof to form the desired profile (e.g., controlling mass flow, pressure, power, ion density, and etchant ratios). In some embodiments, the etching process includes performing a wet etching process and controlling parameters thereof to form the desired widths of each of the channel patterns 110, 116, the middle dielectric isolation layer 140, and the sacrificial gate patterns 608 (e.g., controlling the etchant types).

With continued reference to FIG. 6B, the method may include depositing a blocking oxide layer 626-BO (also referred to herein as "a silicon dioxide layer 626-BO") on (e.g., conformally on) the substrate 106 and the upper and lower channel patterns 110, 116 using, for example, chemical vapor deposition (CVD) or other known deposition techniques. The method may also include depositing a preliminary semiconductor layer 624 on (e.g., conformally on) the blocking oxide layer 626-BO using CVD or other known deposition techniques.

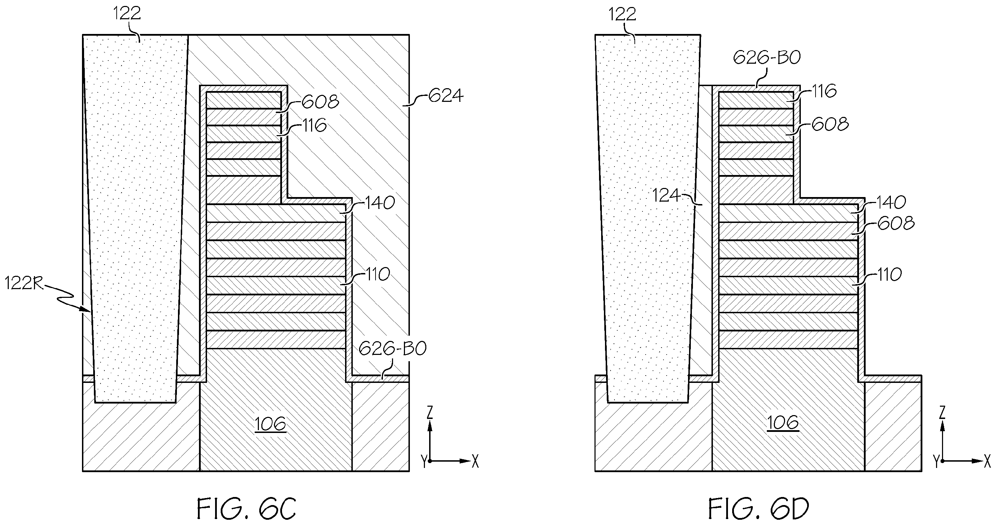

Referring to FIG. 6C, the method may include forming the gate cut region 122. As an example, one or more etching masks (not shown) may be provided on a portion of the preliminary semiconductor layer 624 and/or the substrate 106 such that exposed portions thereof are etched during a subsequent etching processing (e.g., dry and/or wet etching) in which a recess 122R is formed. Subsequently, the recess 122R may be at least partially filled with the insulating material (e.g., at least one of SiN, SiON, SiCN, SiOCN, SiBN, SiOBN, SiOC, and/or combinations thereof) to form the gate cut region 122. In one variation (e.g., the embodiments corresponding to the semiconductor device 300 of FIG. 4B), the recess 122R may be formed such that it contacts an upper surface of the middle dielectric isolation layer 140 and side surfaces of the lower channel patterns 110 to thereby form the gate cut region 322.

Referring to FIG. 6D, the method may include forming the semiconductor material layer 124. As an example, one or more etching masks (not shown) may be provided on respective portions of the upper and lower transistors 104, 102 and the gate cut region 122 such that they overlap (e.g., in the X-axis, Y-axis, and Z-axis directions) a semiconductor layer region 124R. Subsequently, one or more etching processes (e.g., dry and/or wet etching) may be performed to remove the exposed portions of the preliminary semiconductor layer 624 (e.g., the portion that is not in the semiconductor layer region 124R). Accordingly, the unremoved portion (e.g., the portion that is in the semiconductor layer region 124R) may correspond to the semiconductor material layer 124.

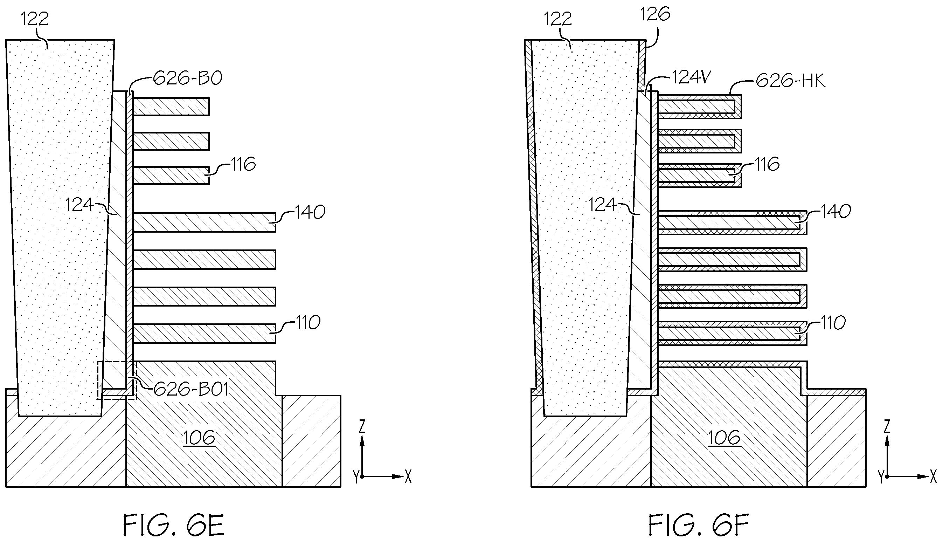

Referring to FIG. 6E, the method may include removing the sacrificial gate patterns 608 and portions of the blocking oxide layer 626-BO that do not directly contact the upper and lower channel patterns 116, 110 (e.g., embodiments corresponding to the insulating layer 126 illustrated in FIG. 3C) using known etching processes, such as a dry/wet etching process, and one or more etching masks. In one variation (e.g., embodiments corresponding to the insulating layer 126 illustrated in FIG. 3A), only a portion of the blocking oxide layer 626-BO that directly contacts both the substrate 106 and the semiconductor material layer 124 (e.g., portion 626-BO1) remains after performing the etching process. In another variation (e.g., embodiments corresponding to the insulating layer 126 illustrated in FIG. 3B), only portions of the blocking oxide layer 626-BO that directly contacts both the substrate 106 and the lower and upper channel patterns 110, 116 remain after performing the etching process. In yet another variation (e.g., embodiments corresponding to the insulating layer 126 illustrated in FIG. 3D), each portion of the blocking oxide layer 626-BO is removed after performing the etching process.

Referring to FIG. 6F, the method may include forming the insulating layer 126 by replacing the removed portions of the block oxide layer 626-BO with high-k dielectric material layer 626-HK portions. As an example, the high-k dielectric material layer 626-HK portions may be deposited using atomic layer deposition (ALD).

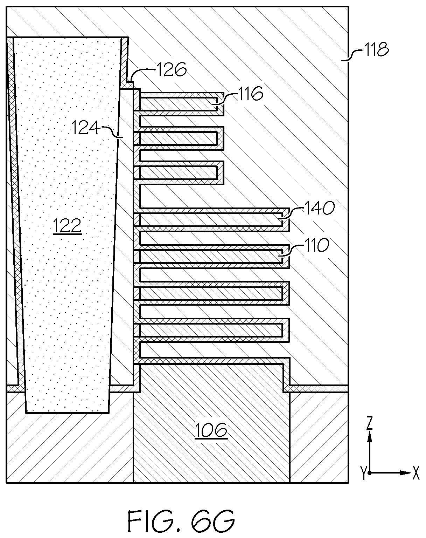

Referring to FIG. 6G, the method may include forming the gate electrode 118 by depositing an electrically conductive material (e.g., using ALD, physical vapor deposition (PVD), and/or electroplating processes) to at least partially fill the recesses defined by the lower and upper channel patterns 110, 116 and to contact the insulating layer 126.

While not shown, the method may also include forming the source/drain regions 132, 134, forming the gate contact structures 120 on the upper channel stack 114, and/or the source/drain contact structure 139 on the source/drain regions 132. The so urce/drain regions 132, 134 may be formed by, for example, selective epitaxial growth at opposing ends of the upper channel stacks 114 and the lower channel stacks 108 between adjacent upper and lower transistors 104, 102, respectively.

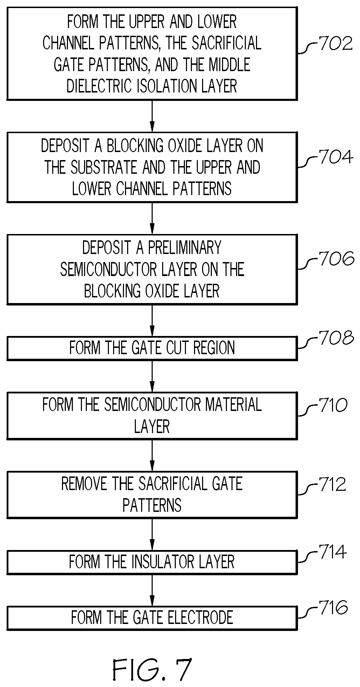

FIG. 7 is a flowchart 700 illustrating a method of forming the semiconductor device according to some embodiments. The method illustrated in flowchart 700 may correspond to intermediate process diagrams described above either alone or in combination, such as the intermediate process diagrams of FIGS. 6A-6G. It should be understood that certain steps may not be performed in various embodiments, and the order of the steps for forming the semiconductor device are not limited to the examples illustrated and described herein.

At step 702, the method may include forming a plurality of channel patterns and sacrificial gate patterns that are alternately stacked on a substrate and forming a middle dielectric isolation layer between the upper channel patterns and the lower channel layers (e.g., the intermediate process illustrated in FIGS. 6A-6B). At step 704, the method may include depositing a blocking oxide layer on the substrate and the upper and lower channel patterns (e.g., the intermediate process illustrated in FIG. 6B), and at step 706, the method may include depositing a preliminary semiconductor layer on the blocking oxide layer (e.g., the intermediate process illustrated in FIG. 6B).

At step 708, the method may include forming the gate cut region 122 (e.g., the intermediate process illustrated in FIG. 6C), and at step 710, the method may include forming the semiconductor material layer (e.g., the intermediate process illustrated in FIG. 6D). At step 712, the method may include removing the sacrificial gate patterns (e.g., the intermediate process illustrated in FIG. 6E), and at step 714, the method may include forming the insulator layer (e.g., the intermediate process illustrated in FIG. 6F). At step 716, the method may include forming the gate electrode (e.g., the intermediate process illustrated in FIG. 6G). According to the present application, the insulator layer may refer to, for example, the insulating layer 126.

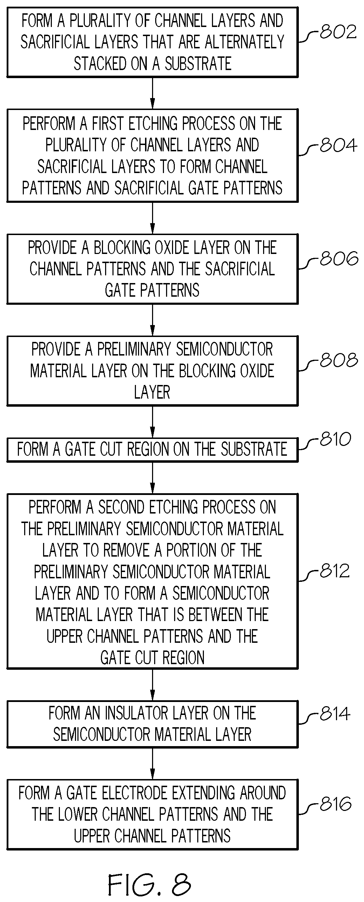

FIG. 8 is a flowchart 800 illustrating a method of forming the semiconductor device according to some embodiments. The method illustrated in flowchart 800 may correspond to intermediate process diagrams described above either alone or in combination, such as the intermediate process diagrams of FIGS. 6A-6G. It should be understood that certain steps may not be performed in various embodiments, and the order of the steps for forming the semiconductor device are not limited to the examples illustrated and described herein.

At step 802, the method may include forming a plurality of channel patterns and sacrificial gate patterns that are alternately stacked on a substrate (e.g., the intermediate process illustrated in FIG. 6A). At step 804, the method may include performing a first etching process (e.g., dry and/or wet etching) on the plurality of channel layers and sacrificial layers to form channel patterns (e.g., upper and lower channel patterns) and sacrificial gate patterns (e.g., the intermediate process illustrated in FIG. 6B). At step 806, the method may include providing (e.g., using CVD) a blocking oxide layer on the sacrificial gate patterns and the upper and lower channel patterns (e.g., the intermediate process illustrated in FIG. 6B), and at step 808, the method may include providing (e.g., using CVD) a preliminary semiconductor layer on the blocking oxide layer (e.g., the intermediate process illustrated in FIG. 6B). At step 810, the method may include forming the gate cut region 122 (e.g., the intermediate process illustrated in FIG. 6C). At step 812, the method may include performing a second etching process (e.g., dry and/or wet etching) on the preliminary semiconductor material layer to remove a portion of the preliminary semiconductor material layer and to form a semiconductor material layer that is between the upper channel patterns and the gate cut region (e.g., the intermediate process illustrated in FIG. 6D). In some embodiments, the second etching process may be performed to form the semiconductor material between the lower channel patterns and the gate cut region. In one variation, the second etching process may be performed to form the semiconductor material that is free from overlap with the lower channel stack in a direction that is parallel to an upper surface of the substrate (e.g., the X-axis direction).

At step 814, the method may include forming the insulator layer on the semiconductor material layer. As an example, forming the insulator layer on the semiconductor material layer may include performing a third etching process (e.g., dry and/or wet etching) to remove the sacrificial gate patterns and to form, based on the blocking oxide layer, a first portion of an insulator layer that is on the semiconductor material layer (e.g., the intermediate process illustrated in FIG. 6E). Subsequently, forming the insulator layer may include providing a second portion of the insulator layer on the semiconductor material layer (e.g., the intermediate process illustrated in FIG. 6F). At step 816, the method may include forming a gate electrode extending around the lower channel patterns and the upper channel patterns (e.g., the intermediate process illustrated in FIG. 6G).

According to the embodiments of the present disclosure, semiconductor devices include a semiconductor material layer (e.g., a polysilicon layer) that is intentionally modified (e.g., to accommodate stacked transistors in an out-bound and/or in-bound standard cell). That is, portions of the semiconductor material layer may be intentionally left unstripped or unremoved. Accordingly, a reduced gate extension may be achieved by selectively retaining portions of the semiconductor material layer, thereby inhibiting parasitic capacitance while maintaining a desired or target gate controllability. However, embodiments of the present disclosure are not limited thereto.

Unless otherwise defined, all terms used herein have the same meaning as commonly understood by one of ordinary skill in the art. Further, all terms should be interpreted as having a meaning that is consistent with their meaning in the context of the relevant art and this disclosure and will not be interpreted in an idealized or overly formal sense unless expressly so defined herein.

In the description above, each example embodiment is described with reference to regions of particular conductivity types. It will be appreciated that opposite conductivity type devices may be formed by simply reversing the conductivity of the n-type and p-type layers in each of the above embodiments. Thus, it will be appreciated that the present disclosure covers both n-channel and p-channel devices for each different device structure.

The terminology used herein is for the purpose of describing particular embodiments only and is not intended to be limiting of embodiments. The singular forms "a," "an," and "the" are intended to include the plural forms as well, unless the context clearly indicates otherwise. The terms "comprises," "comprising," "includes" and/or "including" specify the presence of stated features, steps, operations, elements and/or components, but do not preclude the presence or addition of one or more other features, steps, operations, elements, components and/or groups thereof.

It will be understood that, although the terms "first," "second," etc. are used throughout this specification to describe various elements, these elements should not be limited by these terms. These terms are only used to distinguish one element from another. For example, a first element could be termed a second element, and, similarly, a second element could be termed a first element, without departing from the scope of the present disclosure. The term "and/or" includes any and all combinations of one or more of the associated listed items.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Spatially relative terms such as "below" or "above" or "upper" or "lower" or "top" or "bottom" may be used herein to describe a relationship of one element, layer or region to another element, layer or region based on a frame of reference (e.g., a substrate), as illustrated in the figures. It will be understood that these terms are intended to encompass different orientations of the device in addition to the orientation depicted in the figures.

Example embodiments are described herein with reference to the accompanying drawings, which may include cross-section illustrations that are schematic illustrations of idealized embodiments (and intermediate structures). Many different forms and embodiments are possible without deviating from the teachings of this disclosure. Accordingly, the disclosure should not be construed as limited to the example embodiments set forth herein. As such, it will be understood by those of ordinary skill in the art that various changes in form and details may be made therein without departing from the scope as defined herein. In the drawings, the sizes and relative sizes of layers and regions may be exaggerated for clarity. Additionally, variations from the shapes of the illustrations as a result, for example, of manufacturing techniques and/or tolerances, are to be expected.

Embodiments of the present disclosure are also described with reference to a fabrication operations and flowchart diagrams. It will be appreciated that the steps shown in the fabrication operations and flowchart diagrams need not be performed in the order shown.

The above-disclosed subject matter is to be considered illustrative, and not restrictive, and the appended claims are intended to cover all such modifications, enhancements, and other embodiments, which fall within the scope of the disclosure. Thus, to the maximum extent allowed by law, the scope is to be determined by the broadest permissible interpretation of the following claims and their equivalents, and shall not be restricted or limited by the foregoing detailed description.

## Claims

1. A semiconductor device comprising:
a substrate;
a lower channel stack on the substrate;
an upper channel stack on the lower channel stack;
a gate electrode extending around the lower channel stack and the upper channel stack;
a gate cut region that is on the substrate and comprises an insulating material;
a semiconductor material layer between the upper channel stack and the gate cut region; and
an insulating layer that is between the semiconductor material layer and the upper channel stack.

2. The semiconductor device of Claim 1, wherein the semiconductor material layer comprises at least one of polycrystalline silicon, amorphous silicon, crystalline silicon, doped silicon, or germanium.

3. The semiconductor device of Claim 1 or 2, wherein the insulating layer comprises at least one of silicon dioxide or a dielectric material having a dielectric constant greater than silicon dioxide.

4. The semiconductor device of Claim 3, wherein:
the upper channel stack comprises a plurality of upper channel patterns;
the insulating layer comprises the silicon dioxide and the dielectric material;
portions of the silicon dioxide respectively contact a first surface of each of the plurality of upper channel patterns; and
portions of the dielectric material respectively contact a second surface of each of the plurality of upper channel patterns.

5. The semiconductor device of any one of Claims 1 to 4, wherein a width of the semiconductor material layer in a first direction that is parallel to an upper surface of the substrate is less than or equal to 10 nm.

6. The semiconductor device of any one of Claims 1 to 5, wherein the semiconductor material layer is between the lower channel stack and the gate cut region, and wherein the insulating layer is between the semiconductor material layer and the lower channel stack.

7. The semiconductor device of Claim 6, wherein:
the lower channel stack comprises a plurality of lower channel patterns;
the insulating layer comprises silicon dioxide and a dielectric material having a dielectric constant greater than silicon dioxide;
portions of the silicon dioxide respectively contact a first surface of each of the plurality of lower channel patterns; and
portions of the dielectric material respectively contact a second surface of each of the plurality of lower channel patterns.

8. The semiconductor device of Claim 7, wherein a width of each of the plurality of lower channel patterns in a first direction that is parallel to an upper surface of the substrate is greater than a width of each of the plurality of upper channel patterns in the first direction.

9. The semiconductor device of any one of Claims 1 to 8, further comprising a middle dielectric isolation layer between the lower channel stack and the upper channel stack.

10. The semiconductor device of any one of Claims 1 to 5, wherein the lower channel stack and the semiconductor material layer are free from overlap in a first direction that is parallel to an upper surface of the substrate.

11. The semiconductor device of Claim 10, wherein a width of a lower portion of the semiconductor material layer in the first direction is less than a width of an upper portion of the semiconductor material layer in the first direction.

12. The semiconductor device of any one of Claims 1 to 11, wherein the insulating layer contacts an upper surface of the substrate.

13. The semiconductor device of Claim 1, wherein:
the lower channel stack comprises a plurality of lower channel patterns;
the upper channel stack comprises a plurality of upper channel patterns;
the semiconductor material layer is between the lower channel stack and the gate cut region;
the semiconductor material layer comprises at least one of polycrystalline silicon, amorphous silicon, crystalline silicon, doped silicon, or germanium;
the insulating layer is between the semiconductor material layer and the lower channel stack; and
the insulating layer comprises at least one of silicon dioxide or a dielectric material having a dielectric constant greater than silicon dioxide.

14. The semiconductor device of Claim 13, wherein:
the insulating layer comprises the silicon dioxide and the dielectric material;
portions of the silicon dioxide respectively contact a first surface of each of the plurality of upper channel patterns and a first surface of each of the plurality of lower channel patterns; and
portions of the dielectric material respectively contact a second surface of each of the plurality of upper channel patterns and a second surface of each of the plurality of lower channel patterns.

15. The semiconductor device of Claim 13 or 14, wherein a width of the semiconductor material layer in a first direction that is parallel to an upper surface of the substrate is less than or equal to 10 nm.
